# EUROPÄISCHE PATENTSCHRIFT

(11) **EP 0 583 824 B1**
(45) Veröffentlichungstag und Bekanntmachung des Hinweises auf die Patenterteilung: **19.11.1997**
(21) Anmeldenummer: 93202361.7
(22) Anmeldetag: 11.08.1993
(51) Int. Cl.: G01R 33/34

(54) **Quadraturspulenanordnung für MR-Untersuchungen der Mamma**
Quadrature coil arrangement for magnetic resonance female breast examination
Dispositif de bobines en quadrature pour l'examen mammographique à résonance magnétique

(30) Priorität: 13.08.1992 DE 4226814
(43) Veröffentlichungstag der Anmeldung: 23.02.1994
(73) Patentinhaber: Philips Patentverwaltung GmbH, 22335 Hamburg (DE); Philips Electronics N.V., 5621 BA Eindhoven (NL)
(72) Erfinder: Leussler, Günther Christoph, D-20097 Hamburg (DE)
(74) Vertreter: Hartmann, Heinrich, Dipl.-Ing.

(56) Entgegenhaltungen:
- EP-A- 0 281 787
- EP-A- 0 338 624
- EP-A- 0 342 745
- EP-A- 0 486 086
- FORTSCHR. RöNTGENSTR. Bd. 151, Nr. 1 , 1989 , STUTTGART, DE Seiten 103 - 105 W.A. KAISER UND H. KESS 'PROTOTYP-DOPPELSPULE FÜR DIE MAMMA-MR-MESSUNG'
- PHYSICS IN MEDECINE AND BIOLOGY. Bd. 32, Nr. 2 , 1. Februar 1987 , LONDON GB Seiten 259 - 263 P.W. MCOWAN UND T.W. REDPATH 'A SPECIALISED RECEIVER COIL FOR NMR IMAGING OF FEMALE BREAST'
- JOURNAL OF MAGNETIC RESONANCE. Bd. 78, Nr. 1 , 1. Juni 1988 , ORLANDO, MN US Seiten 69 - 76 P.L. KUHNS U.A. 'INDUCTIVE COUPLING AND TUNING IN NMR PROBES; APPLICATIONS'

## Beschreibung

Die Erfindung betrifft eine Spulenanordnung für MR-Untersuchungen der Mamma. Eine solche Spulenanordnung ist aus dem Aufsatz "Prototyp-Doppelspule für die Mamma-MR-Messung" von Kaiser et al in Fortschr. Röntgenstr. 151,1 (1989), Seiten 103 - 105 bekannt. Diese Spulenanordnung umfaßt zwei Leiterschleifen in parallelen Ebenen, die an eine Empfängeranordnung eines Kernspinuntersuchungsgerätes anschließbar sind. Diese Spulenanordnung dient zur gleichzeitigen Untersuchung beider Brüste und hat ein schlechteres Signal-Rausch-Verhältnis als eine für die Untersuchung einer einzelnen Brust ausgelegte Einzelspule.

Aufgabe der Erfindung ist es, das Signal-Rausch-Verhältnis zu verbessern. Diese Aufgabe wird bei einer Spulenanordnung für MR-Untersuchungen der Mamma gelöst mit einer ersten Spulenanordnung, die auf der Mantelfläche eines Zylinders in zueinander parallelen Ebenen mehrere lediglich induktiv miteinander gekoppelte Leiterschleifen umfaßt, von denen eine an einen Eingang einer Empfängeranordnung anschließbar ist und mit einer als Oberflächenspule vom Butterflytyp ausgebildeten zweiten Spulenanordnung, die sich an einer der Stirnflächen der ersten Spulenanordnung befindet und an einen weiteren Eingang der Empfängeranordnung anschließbar ist.

Bei der Erfindung dienen die erste und die zweite Spulenanordnung gemeinsam zur Mamma-Untersuchung. Die erste Spulenanordnung ist in der DE-OS 38 16 831 im einzelnen beschrieben. Die zweite Spulenanordnung ist eine Oberflächenspule vom Butterfly-Typ, die in der EP-OS 338 624 beschrieben ist. Auf beide Veröffentlichungen wird ausdrücklich bezug genommen.

Die erste Spulenanordnung kann Hochfrequenzmagnetfelder mit zur Zylinderachse paralleler Feldrichtung detektieren, während die zweite Spulenanordnung, die in einer zu den Ebenen der Leiterschleifen der ersten Spulenanordnung parallelen Ebene liegt, Hochfrequenzmagnetfelder detektieren kann, die senkrecht zur Zylinderachse verlaufen.

Beide Hochfrequenzspulenanordnungen zusammen wirken daher als Quadraturspulenanordnung mit besonders günstigem Signal-Rausch-Verhältnis.

Eine Weiterbildung der Erfindung sieht vor, daß die Öffnung zwischen den Außenleitern der zweiten Spulenanordnung größer ist als die von den einzelnen Leiterschleifen der ersten Spulenanordnung umschlossene Öffnung. Dadurch wird der Bereich innerhalb der beiden Spulenanordnungen, für den sich das bestmögliche Signal-Rausch-Verhältnis ergibt, in Richtung auf diejenige Stirnfläche der ersten Spulenanordnung verschoben, die weiter von der zweiten Spulenanordnung entfernt ist, und zwar umso mehr, je größer die Abmessungen der zweiten Spulenanordnung im Verhältnis zu denen der ersten sind.

Die Erfindung wird nachstehend anhand der Zeichnung näher erläutert. Es zeigen:
Fig. 1 ein Kernspinuntersuchungsgerät, bei dem die Erfindung anwendbar ist,
Fig. 2 einen Querschnitt durch einen Teil dieses Gerätes,
Fig. 3 eine erste Ausführungsform der Spulenanordnung und
Fig. 4 deren Anschluß an die Empfängeranordnung in einem Kernspin untersuchungsgerät und
Fig. 5 eine zweite Ausführungsform der Spulenanordnung.

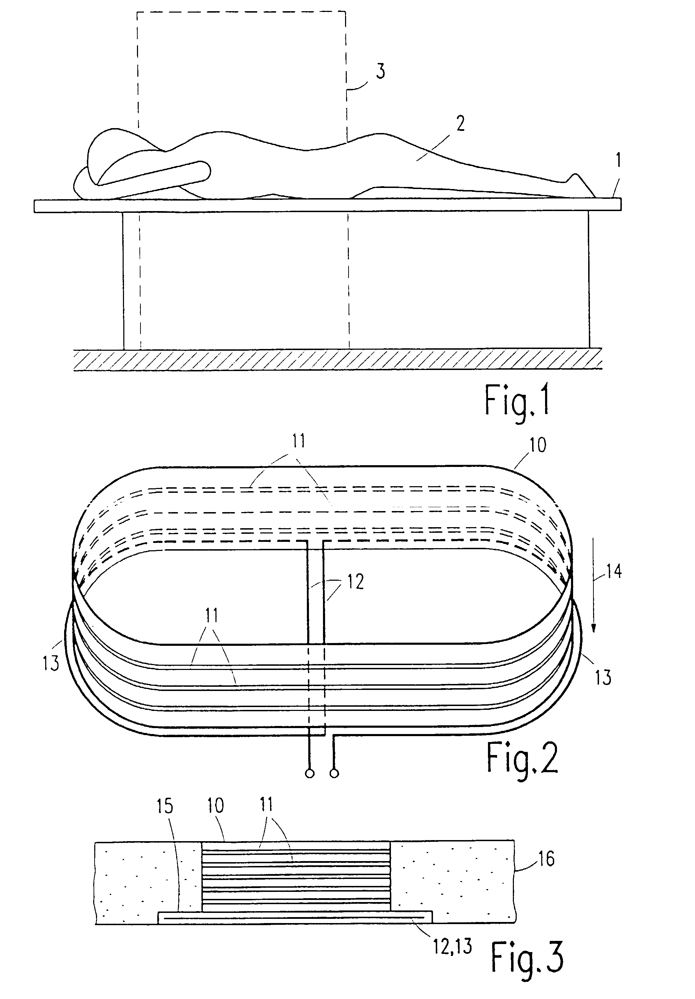

Fig. 1 zeigt ein Kernspinuntersuchungsgerät mit einer Patientenliege 1, auf der bei einer Untersuchung eine Patientin 2 mit dem Gesicht nach unten gelagert wird. Der gestrichelte Block 3 enthält einen Hauptfeldmagneten, der ein starkes homogenes horizontal verlaufendes Magnetfeld erzeugt. Außerdem ist darin eine Hochfrequenzsendespule vorgesehen, die im Untersuchungsbereich ein zu dem stationären Magnetfeld senkrechtes hochfrequentes Magnetfeld mit einer Frequenz erzeugt, die linear von der Stärke des stationären Magnetfeldes abhängt. Die Hochfrequenzsendespule wird impulsweise betrieben. Außerdem umfaßt der Block 3 u.a. noch Gradientenspulen, die während oder nach den Hochfrequenzimpulsen magnetische Gradientenfelder mit in unterschiedlichen Richtungen wirksamen Gradienten erzeugen können.

In Fig. 2 ist eine für Mamma-Untersuchungen geeignete Spulenanordnung dargestellt. Diese Spulenanordnung umfaßt eine erste Spulenanordnung, die auf einem zylinderförmigen Trägerkörper 10 in mehreren parallelen Ebenen Leiterschleifen 11 enthält, die lediglich induktiv miteinander gekoppelt sind und von denen eine an den Eingang einer Empfängeranordnung anschließbar ist. Derartige Hochfrequenzspulenanordnungen sind aus der DE-OS 38 16 831 bekannt, worauf ausdrücklich bezug genommen wird.

Wie bereits erwähnt, hat der Trägerkörper Zylinderform, d.h. seine Querschnitte in verschiedenen zur Zylinderachse senkrechten Querschnittsebenen sind identisch. Der hohlzylindrische Trägerkörper, der aus einem nichtleitenden Material besteht, vorzugsweise aus Kunststoff, ist in seinen Abmessungen der Anatomie der zu untersuchungen Patientin angepaßt, so daß bei einer Untersuchung das Innere des Trägerkörpers beide Brüste gleichzeitig aufnehmen kann. Der Trägerkörper kann eine Höhe von z.B. 6 cm haben, wobei seine Wände im mittleren Teil des Trägerkörpers eben sind und voneinander einen Abstand von z.B. 16 cm haben. Die ebenen Wände im mittleren Bereich sind beiderseits über Randpartien mit bogenförmigem Querschnitt miteinander verbunden, so daß sich in Längsrichtung (d.h. in der horizontalen Richtung der Fig. 2) Abmessungen von 33 cm ergeben.

In Fig. 2 sind lediglich drei Leiterschleifen dargestellt. Insbesondere bei niedrigeren Frequenzen, d.h. bei Kernspinuntersuchungsgeräten mit einem schwächeren stationären Magnetfeld, sollten aber mehr Leiterschleifen vorgesehen sein, beispielsweise fünf. Eine derartige Hochfrequenzspulenanordnung ist in der Lage, Hochfrequenzmagnetfelder zu detektieren, die parallel zur Zylinderachse verlaufen.

In einer Ebene unmittelbar an der unteren Stirnfläche des zylinderförmigen Trägerkörpers 10 befindet sich eine als Oberflächenspule ausgebildete zweite Spulenanordnung, die Hochfrequenzmagnetfelder detektieren kann, die senkrecht zu der Zylinderachse verlaufen. Diese Oberflächenspule kann auf eine nicht näher dargestellte Trägerplatte aufgebracht sein. Die Oberflächenspule ist vom sogenannten Butterfly-Typ. Derartige Spulen sind aus der EP-OS 338 624 sowie der darin erwähnten Veröffentlichung bekannt. Darauf wird ausdrücklich bezug genommen. Die Oberflächenspule besitzt zwei parallel und dicht nebeneinander verlaufende Mittelleiter 12, die in zwei spiegelbildlich gleichartige Schleifenteile münden, die zusammen eine Schleife ergeben, deren Form einer der Leiterschleifen 11 entspricht, zweckmäßigerweise jedoch größere Abmessungen hat. Der Schleifenteil, dessen Mittelleiter mit einer Anschlußklemme der Spule verbunden ist, endet im Mittelleiter des anderen Schleifenteils und dieser andere Schleifenteil endet in einer weiteren Anschlußklemme der Spule. Der Strom durch die beiden Mittelleiter hat die gleiche Richtung, die entgegengesetzt ist zu der Richtung des Stroms durch die Außenleiter 13. Dadurch kann diese Spule Hochfrequenzfelder detektieren, die senkrecht zur Achse des Zylinders 10 und senkrecht zu den Mittelleitern 12 verlaufen.

Da die hochfrequenten Magnetfelder, die durch Kernresonanz in einem Kernspinuntersuchungsgerät entstehen können, stets senkrecht zur Richtung des homogenen stationären Magnetfeldes verlaufen, muß die gesamte Spulenanordnung 10 .... 13 so in das Kernspinuntersuchungsgerät eingeführt werden, daß die beiden Magnetfeldrichtungen, die von der ersten und der zweiten Spulenanordnung detektiert werden können, senkrecht zur Richtung des homogenen stationären Magnetfeldes stehen, d.h., das homogene stationäre Magnetfeld muß bei der Untersuchung - wie durch den Pfeil 14 angedeutet - parallel zu den Mittelleitern 12 verlaufen. Die Spulenanordnung 10 .... 13 muß also dementsprechend im Kernspinuntersuchungsgerät plaziert werden. Dies könnte bei jeder Untersuchung manuell durch den Benutzer erfolgen. Günstiger ist es, wenn wenigstens eine der beiden Spulenanordnungen durch eine feste Verbindung mit dem Gerät bzw. ein darin einbringbares Teil in eine definierte Position gebracht wird.

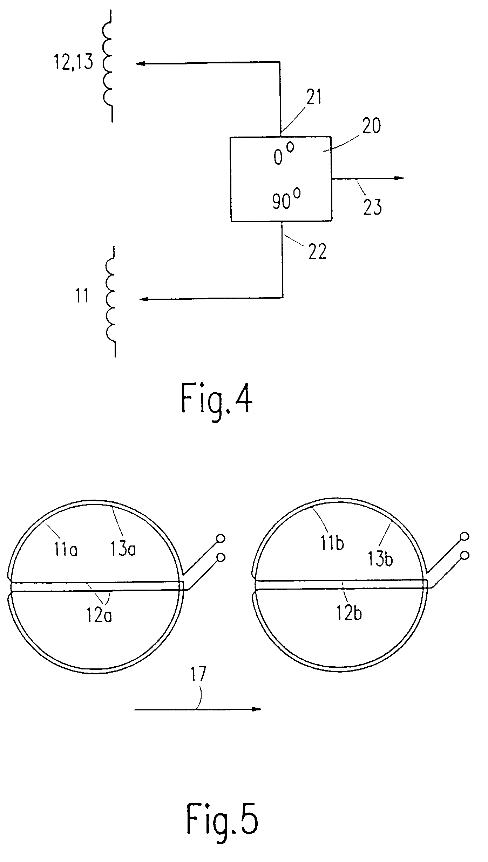

Fig. 3 zeigt einen Ausschnitt aus einem flachen Kissen 16, das bei einer Mamma-Untersuchung auf die Patientenliege 1 auflegbar ist und auf das sich die Patientin bei einer Mammauntersuchung legt. Die Spulenanordnung gem. Fig. 2 ist in dieses Kissen eingebettet, wobei mit 15 die Platte bezeichnet ist, die die Oberflächenspule 12, 13 trägt.

Das Einbringen des Kissens in das Kernspinuntersuchungsgerät verringert den zur Untersuchung zur Verfügung stehenden Raum. Eine insoweit günstigere Lösung wäre es, die Hochfrequenzspulenanordnung in der Tischplatte der Patientenliege 1 vorzusehen. Diese Lösung setzt allerdings voraus, daß beide Spulenanordnungen beispielsweise durch Pin-Dioden abgeschaltet werden können, damit darin beim Einschalten der Hochfrequenzsendespule für andere Untersuchungen keine nennenswerten Ströme fließen können.

Es ist auch möglich, nur eine der beiden Spulenanordnungen fest mit dem Kernspinuntersuchungsgerät zu verbinden; beispielsweise kann die Oberflächenspule 13 (mit geeigneter Abschaltmöglichkeit) auf der der Patientin zugewandten Tischplattenfläche der Liege 1 angeordnet sein. Die Spulenanordnung 10, 11 muß dann bei einer Mamma-Untersuchung darauf aufgesetzt und dazu ausgerichtet werden.

Wie bereits erwähnt, wirken die Spulenanordnungen 11 - 12, 13 als Quadraturspule. Fig. 4 zeigt - rein schematisch - eine Schaltung zur Verarbeitung der von den beiden Spulenanordnungen gelieferten Signale. Das wesentliche Bauelement ist dabei ein Quadraturkombinierer 20 mit einem ersten Eingang 21 und einem zweiten Eingang 22. Das Signal am Ausgang 23 des Kombinierers entspricht dem Produkt des Signals am Eingang 21 und des um 90° gedrehten Signals am Eingang 22. Am Eingang 21 ist die Oberflächenspule 12, 13 angeschlossen und am Eingang 22 die Spulenanordnung mit den Leiterschleifen 11.

Für den Fachmann versteht sich von selbst, daß die Spulenanordnungen dabei durch geeignet gemessene Kapazitäten auf die Frequenz des Kernresonanzsignals abgestimmt sind und daher als Resonatoren wirken. Diese Kapazitäten sind hier nicht dargestellt.

Die optimale Wirkung einer Quadraturspulenanordnung (mit einer Verbesserung des Signal-Rausch-Verhältnisses um 3 dB ergibt sich nur für die räumlichen Bereiche, in denen der Verfall der Kernmagnetisierung in beiden Spulen gleich große Signale addiert. Der Abstand dieses Bereiches von der Ebene der Oberflächenspule 12, 13 hängt von deren Abmessungen in Relation zu den Abmessungen der Spulenanordnung 11 ab. Er ist umso weiter von der genannten Ebene entfernt, je größer die Abmessungen der Oberflächenspule im Vergleich zu den Leiterschleifen 11 sind. Ein geeigneter Wert ergibt sich, wenn die Abmessungen der Oberflächenspule 20 cm - in Richtung parallel zu den Mittelleitern 12 - bzw. 40 cm - in Richtung senkrecht dazu - betragen. Die Abmessungen sind rund 1,25 mal so groß wie die der Leiterschleifen 11.

Die in Fig. 2 dargestellte Spulenanordnung entfaltet ihre Vorteile nur dann, wenn das homogene stationäre Magnetfeld in dem Kernspinuntersuchungsgerät in Tischlängsrichtung verläuft. Verläuft es in horizontaler Richtung aber senkrecht zur Tischlängsrichtung, ist im wesentlichen nur die erste Spulenanordnung (11) wirksam, während bei vertikalem Feldverlauf die Spule 11 unwirksam ist. In Fig. 5 ist nun eine Spulenanordnung dargestellt, die die Mamma-Untersuchung gestattet, wenn das homogene stationäre Magnetfeld horizontal, aber senkrecht zur Tischlängsrichtung verläuft. Fig. 5 stellt eine Draufsicht auf die Spulenanordnung dar, wobei erkennbar wird, daß sie aus zwei identischen und voneinander unabhängigen Teilen besteht. Jeder Teil für sich gestattet nur die Untersuchung einer einzelnen Brust und umfaßt eine Spulenanordnung 11a bzw. 11b, die entsprechend der Anordnung 11 in Fig. 2 mehrere gleich geformte, gleich große und zueinander konzentrische Leiterschleifen 11a bzw. 11b in zueinander parallelen Ebenen umfaßt sowie je eine - ähnlich wie bei der Anordnung nach Fig. 2 - in ihrer Form und in ihren Abmessungen daran angepaßte Oberflächenspule 12a, 13a bzw. 12b, 13b in einer zu den genannten Ebenen parallelen Ebene. Bei der in Fig. 5 dargestellten Richtung der Mittelleiter 12a, 12b wirkt diese Spulenanordnung optimal, wenn das homogene stationäre Magnetfeld in Richtung des Pfeiles 17 verläuft, d.h. senkrecht zur Zeichenebene der Fig. 1.

Wenn die Leiterschleifen 11a, 11b und daran angepaßt die Außenleiter 13a, 13b wie in Fig. 5 dargestellte Kreisform haben, können diese Spulenanordnungen auch bei Kernspinuntersuchungsgeräten eingesetzt werden, bei denen das homogene stationäre Magnetfeld in Tischlängsrichtung verläuft. Dazu müssen die beiden Spulenanordnungen lediglich um jeweils 90° gedreht werden. Der Vorteil gegenüber der Spulenanordnung nach Fig. 2 besteht in einem verbesserten Signal-Rausch-Verhältnis. Der Nachteil besteht darin, daß für jede der beiden Spulenanordnungen 11a ..... 13a bzw. 11b ..... 13b eine Schaltung gemäß Fig. 4 und der ihr nachgeschaltete analoge bzw. digitale Verarbeitungsteil erforderlich ist. Dieser Nachteil ließe sich zwar vermeiden, wenn die Brüste nacheinander mit nur einer der in Fig. 5 dargestellten Spulenanordnung untersucht würden. Dies würde aber die Untersuchungszeit verlängern, und außerdem wären Untersuchungen mit Kontrastmittel, bei denen der zeitliche Verlauf der Kontrastmittelanreicherung registriert werden soll, praktisch nicht möglich.

## Patentansprüche

1. Quadraturspulenanordnung für MR-Untersuchungen der Mamma mit einer ersten Spulenanordnung, die auf der Mantelfläche eines Zylinders in zueinander parallelen Ebenen mehrere lediglich induktiv miteinander gekoppelte Leiterschleifen umfaßt, von denen eine an einen Eingang einer Empfängeranordnung anschließbar ist und mit einer als Oberflächenspule vom Butterflytyp ausgebildeten zweiten Spulenanordnung, die sich an einer der Stirnflächen der ersten Spulenanordnung befindet und an einen weiteren Eingang der Empfängeranordnung anschließbar ist.

2. Quadraturspulenanordnung nach Anspruch 1,
dadurch gekennzeichnet, daß die Öffnung zwischen den Außenleitern der zweiten Spulenanordnung größer ist als die von den einzelnen Leiterschleifen der ersten Spulenanordnung umschlossene Öffnung.

3. Kernspinuntersuchungsgerät mit einer Patientenliege zur Lagerung einer zu untersuchenden Person und mit einer Quadraturspulenanordnung nach Anspruch 1 oder 2,
dadurch gekennzeichnet, daß entweder die Patientenliege mit einer Öffnung zur Aufnahme der ersten Spulenanordnung vorgesehen ist oder daß ein auf die Patientenliege auflegbares Kissen vorgesehen ist, in das die beiden Spulenanordnungen integriert sind, daß in dem von der ersten Spulenanordnung umschlossenen Bereich eine Öffnung frei bleibt und daß die zweite Spulenanordnung sich im Bereich der unteren Stirnfläche der ersten Spulenanordnung befindet.

## Claims

1. A quadrature coil system for MR mammography, including a first coil system, comprising a plurality of conductor loops which are merely inductively coupled to one another and are arranged on the surface of a cylinder in mutually parallel planes, one of said loops being connectable to an input of a receiving device, and a second coil system which is constructed as a surface coil of the butterfly type, is situated at one of the end faces of the first coil system, and can be connected to a further input of the receiving device.

2. A quadrature coil system as claimed in Claim 1, characterized in that the opening enclosed by the outer conductors of the second coil system is larger than that enclosed by the individual conductor loops of the first coil system.

3. A magnetic resonance examination apparatus, comprising a patient support for a person to be examined and a quadrature coil svstem as claimed in Claim 1 or 2, characterized in that either the patient support is provided with an opening for accommodating the first coil system, or that there is provided a cushion which can be arranged on the patient support and in which the two coil systems are integrated, that an opening remains free in the area enclosed by the first coil system, and that the second coil system is arranged at the area of the lower end face of the first coil system.

## Revendications

1. Dispositif de bobines en quadrature pour l'examen mammographique par résonance magnétique avec un premier dispositif de bobines, qui comprend, sur la surface enveloppe d'un cylindre, dans des plans parallèles entre eux, plusieurs boucles de conducteur couplées les unes aux autres simplement par induction, dont une peut être connectée à une entrée d'un dispositif récepteur et avec un deuxième dispositif de bobines réalisé sous la forme d'une bobine de surface de type papillon qui se trouve à l'une des faces d'about du premier dispositif de bobines et peut être connectée à une autre entrée du dispositif récepteur.

2. Dispositif de bobines en quadrature suivant la revendication 1, caractérisé en ce que l'ouverture entre les conducteurs extérieurs du deuxième dispositif de bobines est plus grande que l'ouverture délimitée par les diverses boucles de conducteur du premier dispositif de bobines.

3. Appareil d'examen à spin nucléaire avec une table d'examen pour recevoir une personne à examiner et avec un dispositif de bobines en quadrature suivant la revendication 1 ou 2, caractérisé en ce que la table d'examen est pourvue d'une ouverture pour recevoir le premier dispositif de bobines, ou un coussin à disposer sur la table d'examen est prévu, dans lequel les deux dispositifs de bobines sont intégrés, qu'il subsiste une ouverture libre dans le domaine délimité par le premier dispositif de bobines et que le deuxième dispositif de bobines se trouve dans le domaine de la face d'about inférieure du premier dispositif de bobines.
